# EUROPEAN PATENT SPECIFICATION

(11) **EP 3 226 540 B1**
(45) Date of publication and mention of the grant of the patent: **17.03.2021**
(21) Application number: 17161629.5
(22) Date of filing: 17.03.2017
(51) Int. Cl.: H04N 5/225, H04N 17/00

(54) **METHOD OF MAKING A CAMERA FOR USE ON A VEHICLE**
VERFAHREN ZUR HERSTELLUNG EINER KAMERA ZUR VERWENDUNG AUF EINEM FAHRZEUG
PROCÉDÉ DE FABRICATION D'UNE CAMÉRA DESTINÉE À ÊTRE UTILISÉE SUR UN VÉHICULE

(30) Priority: 30.03.2016 US 201615084896
(43) Date of publication of application: 04.10.2017
(60) Divisional application: 18177126.2
(73) Proprietor: Aptiv Technologies Limited, St. Michael (BB)
(72) Inventor: LOW, Yew Kwang, 738082 Singapore (SG); EVERLY, Ward K., WESTFIELD, INDIANA 46074 (US); TAYLOR, Ronald M., Greentown, INDIANA 46936 (US)
(74) Representative: Manitz Finsterwald Patent- und Rechtsanwaltspartnerschaft mbB

(56) References cited:
- US-A1- 2005 077 458
- US-A1- 2007 183 773
- HONGTAO HAN ET AL: "Low cost camera modules using integration of wafer-scale optics and wafer-level packaging of image sensors", ASIA COMMUNICATIONS AND PHOTONICS CONFERENCE AND EXHIBITION,, 2 November 2009 (2009-11-02), pages 1-7, XP031623441, ISBN: 978-1-55752-877-3

## Description

### TECHNICAL FIELD

The subject matter of this disclosure generally relates to cameras. More specifically, and without limitation, the subject matter of this disclosure pertains to making a camera using a method that includes surface mount technology.

### DESCRIPTION OF THE RELATED ART

Over the last several decades there have been significant changes in camera technology. The proliferation of digital cameras and advances in associated technologies has made it possible to incorporate cameras in a variety of devices. Computers and mobile communication devices, such as smartphones, routinely include cameras. It is also becoming more commonplace to provide one or more cameras on an automotive vehicle to provide enhanced features, such as a parking assist function. It would be useful to be able to provide more advanced driver assist functions that incorporate or use a camera. Document US 2005/077458 A1 relates to an integrally-packaged imaging module. Document US 2007/183773 A1 relates to a camera module. Document from the Asia Communications and Photonics Conference and Exhibition, 2 November 2009, pages 1-7, XP031623441 relates to a low cost camera modules using integration of wafer scale.

One of the challenges associated with developing a camera for use on a vehicle is providing adequate image quality capability while fitting within size and cost constraints. Another challenge is providing a variety of different camera capabilities or features within cost and space constraints.

### SUMMARY

The invention is defined in the appended claims and relates to a method of making a camera. Said method includes assembling a plurality of lens elements, a sensor, and a housing to establish an assembly with each of the lens elements and the sensor at least partially in the housing. The assembly is then situated adjacent a circuit board substrate. At least the sensor is secured to the circuit board substrate using surface mount technology (SMT) and the assembly is fixed relative to the circuit board substrate.

The method according to the invention comprises further: providing a ball grid array on a side of the sensor, performing the situating by situating the ball grid array adjacent a soldering paste on the circuit board substrate, and performing the securing using reflow soldering. The reflow soldering may establish a secure connection between at least some material of the ball grid array and the circuit board substrate. The reflow soldering may establish a secure connection between at least some of the housing and the circuit board substrate The method according to the invention comprises further determining a performance of the camera at an elevated temperature during the securing.

Various features and advantages of at least one disclosed example embodiment will become apparent to those skilled in the art from the following detailed description. The drawings that accompany the detailed description can be briefly described as follows.

### BRIEF DESCRIPTION OF THE DRAWINGS

Figure 1 is a perspective illustration of an example embodiment of a camera.
Figure 2 schematically illustrates an example method of making a camera according to an embodiment of this invention.
Figure 3 schematically illustrates a portion of another example technique of making a camera designed according to an embodiment of this invention.
Figure 4 schematically illustrates another example camera embodiment.
Figure 5 schematically illustrates selected features of an example embodiment of a camera.
Figure 6 illustrates selected features of an example camera embodiment associated with a windshield of an automotive vehicle.
Figure 7 schematically summarizes another camera and assembly technique designed according to an embodiment of this invention.

### DETAILED DESCRIPTION

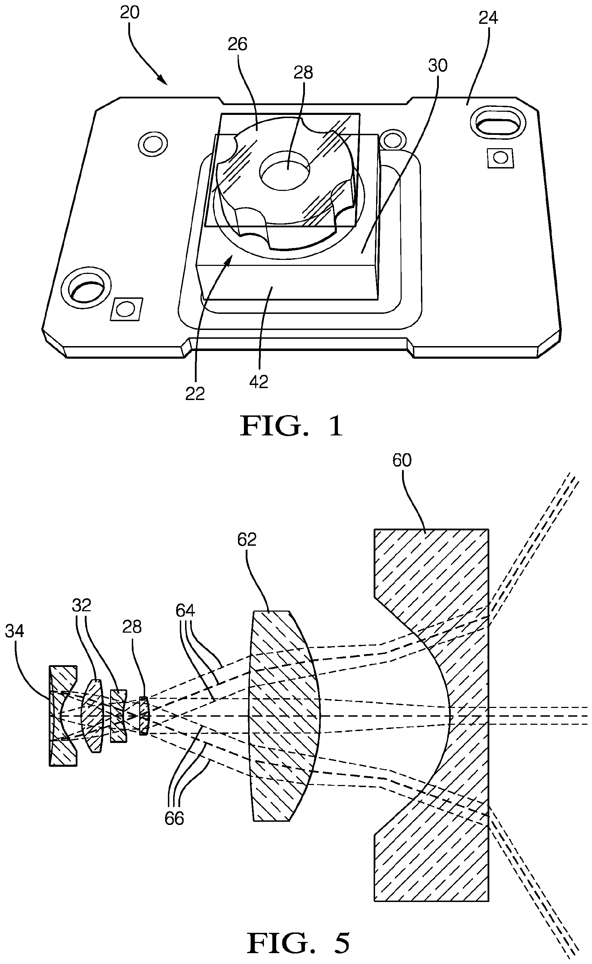

Figure 1 illustrates a camera 20 that is useful on an automotive vehicle to provide advanced driver assistance features. The example camera 20 includes an assembly 22 secured to a circuit board substrate 24. One of the features of the example camera 20 is that the assembly 22 is secured to the circuit board substrate 24 using surface mount technology (SMT). As can be appreciated from Figure 1, the assembly 22 includes a barrel 26, a front lens element 28 and a housing 30.

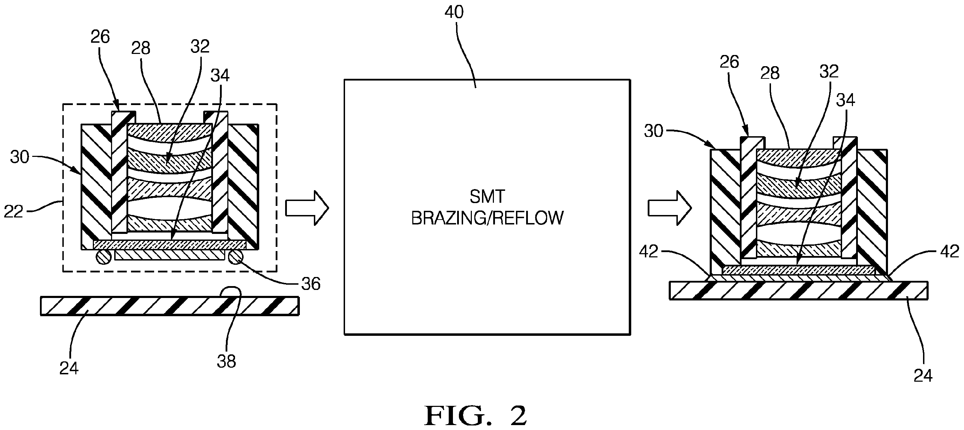

Figure 2 schematically illustrates an example method of making a camera, such as the camera 20 shown in Figure 1. In this example, a plurality of lens elements 28-32 are situated within the barrel 26. A sensor 34 is at least partially within the housing 30. The sensor 34 operates in a known manner for detecting radiation, such as visible light, and producing an output that is useful for image generation, for example. The particular type of sensor and lens elements may be varied and those of skill in the art who have the benefit of this description will be able to select lens elements and a sensor that meet their particular needs.

In this example, pre-assembling the sensor 34 and the lens elements 28-32 within the housing 30 provides a desired and precise alignment of the sensor 34 with the lens elements 28-32. The entire assembly 22 is then situated on the circuit board substrate 24. In the illustrated example, the sensor 34 includes a plurality of connecting elements 36, which in this example are a ball grid array made of a metal that is suitable for brazing or soldering. Such materials are known. The circuit board substrate 24 includes a soldering paste 38 that may be printed on selected locations where the assembly 22 will be situated.

As schematically shown at 40, a brazing or reflow oven sufficiently heats the connecting elements 36 and the soldering paste 38 where the assembly 22 is soldered and secured in positon on the circuit board substrate 24.

The resulting camera 20 is shown on the right side of Figure 2. At least the sensor 34 is soldered or secured to the circuit board substrate 24. The connection between the sensor 34 and the remainder of the assembly 22, such as through the housing 30, results in the entire assembly 22 being secured to the circuit board substrate 24 as a result of the connection between the sensor 34 and the circuit board substrate 24. In the illustrated example, the connection between the housing 30 and the circuit board substrate 24 includes a dispensed material 42.

The illustrated camera made using SMT is significantly reduced in size compared to previous automotive vehicle camera arrangements. For example, one embodiment of a camera 20 provides a volumetric reduction of lens space on the order of 78 percent and a total weight reduction on the order of 45 percent compared to previous camera arrangements. In one example, the housing 30 occupies a space of 12mm x 12mm on the circuit board substrate 24. In some example embodiments, a height of the assembly 22 between the circuit board substrate 24 and the front lens element 28 is less than 10mm. In some example embodiments, the height is less than 5mm. In some example embodiments, the camera weight is less than 7 grams, which is significantly less than previous camera arrangements, which would weigh close to 12 grams.

The smaller dimensions of the assembly 22 facilitate a SMT approach, in part, because SMT machines typically require component heights less than 13mm for reliable pick and place by a standard tool prior to a solder reflow oven process. The ability to use SMT for making the camera 20 provides significant cost savings because it allows for a higher level of automation and process cost savings.

Another feature of the illustrated example is that the pre-alignment of the lens elements 28-32 and the sensor 34 within the assembly 22 increases the reliability and accuracy of the resulting camera. Therefore, there is a lower likelihood that cameras made according to the illustrated technique will fail an inspection or quality testing compared to previous techniques that include mounting a sensor to the circuit board substrate and subsequently mounting the lens assembly and housing to the board with the sensor already in place.

Another reliability enhancement is provided by the disclosed process. Automotive vehicle cameras are potentially subjected to a wide range of temperatures depending on where the vehicle is located. For example, the ambient temperature may range from -40° C to 105° C. In operation and for high temperature testing, the camera internal temperature is usually 15 to 20 degrees higher than that (e.g. 120° C to 125° C). The disclosed technique and camera configuration make it possible to measure the camera image quality at elevated temperatures, such as temperatures up to 125° C. This allows for verification of high temperature performance during the reflow process.

The high temperatures used during the securing within the reflow oven, for example, are also potentially useful for high temperature camera testing. One example embodiment includes using a high temperature harness within the reflow oven to power and access the camera to capture images. According to an example embodiment, an internal camera software program that calculates the image quality metrics is initiated and referenced while the camera is viewing a preselected target when the camera is subjected to a temperature in the range from about 105° C to about 125° C.

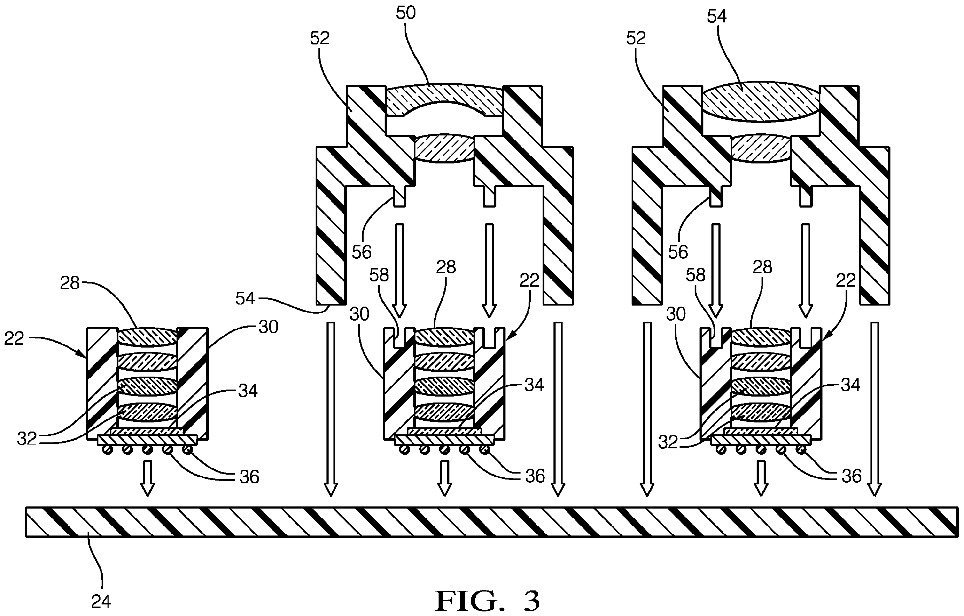

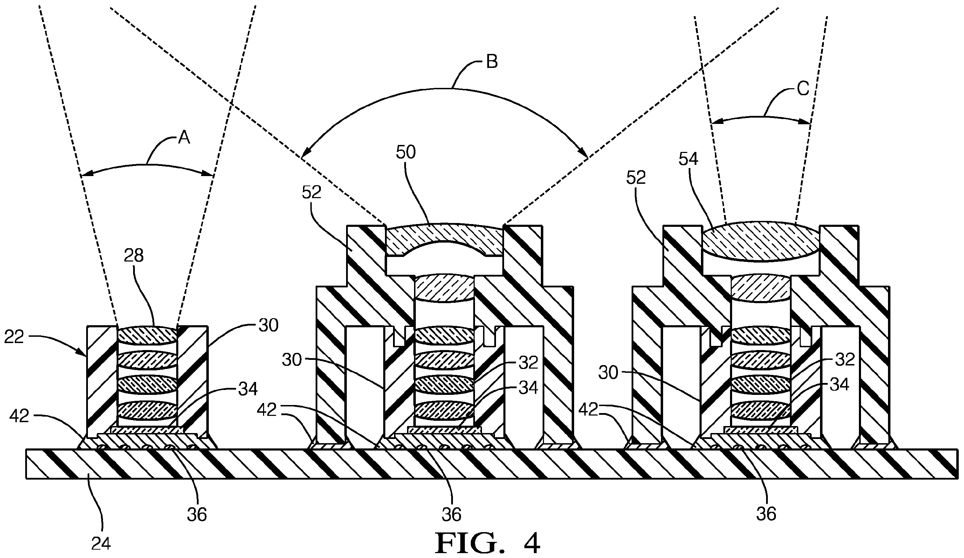

Figures 3 and 4 illustrate an arrangement of multiple assemblies 22 on a single circuit board 24 to provide a trifocal camera. In this example, three individual assemblies 22 are positioned on the circuit board 24 in desired locations. One of the assemblies 22 is provided with an optical objective 50 for altering the field of view compared to at least one other of the assemblies 22. The objective 50 is supported on an objective housing 52 that is configured to be at least partially received against the circuit board substrate 24. In this example, a thermal curable material or an ultraviolet and thermal curable material is provided at the interface between the objective housing 52 and the circuit board substrate 24 to provide a secure attachment between those components. In this example, mounting features 56 are configured to be received within locator features 58 on the housing 30 to ensure a desired alignment between the objective 50, the lens elements 28 - 32 and the sensor 34.

In the example of Figure 3, a different objective 54 is provided for another one of the assemblies 22 to realize a third field of view. Figure 4 schematically illustrates three different fields of view in this example. A first field of view represented by the angle A may be on the order of 52°, for example. A second field of view represented by the angle B may be on the order of 150°. A third field of view represented by the angle C may be on the order of 30°. Given this description, those skilled in the art will realize what fields of view will best suit their particular needs, will be able to configure the arrangement of multiple assemblies 22 on a single circuit board substrate 24, and can select appropriate objectives to realize a desired camera arrangement. While a trifocal camera is shown in Figures 3 and 4, a bifocal arrangement is also possible using two assemblies 22.

One of the features shown in Figures 3 and 4 is that an inventory of assemblies 22 that have the same configuration may be individually supplemented with a variety of objectives to get different fields of view for achieving different purposes and different types of camera function. In one example, the camera with the field of view A is used for imaging purposes, the camera with the field of view B is used as a front side view sensor and the camera with the field of view C is used for object detection.

Figure 5 schematically illustrates an example feature of a wide field objective that includes objective lens elements 60 and 62. Radiation, such as visible light, passing through the objective elements 60 and 62 results in parallel rays such as those shown at 64 and 66, respectively. Having rays that are parallel between the objective element 62 and the front lens element 28 accommodates assembly tolerances when an objective is provided for a camera 20. For example, if the objective elements 60 and 62 were slightly tilted (e.g., tilted slightly to the right or left according to the drawing) or slightly off center from the sensor 34 (e.g., moved slightly upward or downward according to the drawing), that could cause problems for achieving a desired output from the sensor 34.

The objective elements 60 and 62 are configured in this example to create collimated or parallel rays refracting into the interior lens assembly. The result provides an insensitivity in terms of assembly tolerances (e.g., decentering, z-positioning, tilting). If the refracted rays do not focus to the same degree across the plane degrading effects are more pronounced and variable. The objective elements 60, 62 could also allow for additional components such as filters to be inserted into the path of the parallel rays between the objective and the interior lenses without affecting the focus or other aberration corrections because the exiting light is collimated.

Designing the objective elements 60 and 62 to provide the parallel rays at 64 and parallel rays at 66, for example, reduces the sensitivity to such misalignment possibilities. For example, centering tolerances on the order of +/-0.1mm and tilting tolerances on the order of +/- 0.5° are effectively accommodated with an arrangement such as illustrated in Figure 5. Additionally, a tolerance in the spacing between the objective elements and the sensor 34 can be accommodated on the order of +/- 0.1mm.

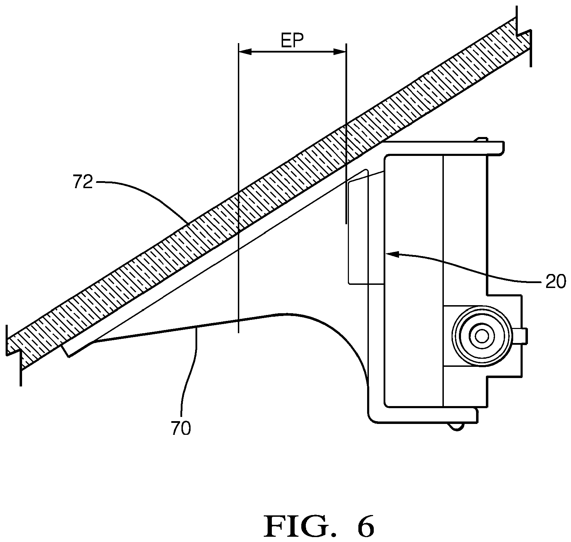

Figure 6 schematically illustrates a camera 20 supported within a housing 70 that is configured to be mounted adjacent a vehicle windshield 72. With the camera 20 being designed according to an embodiment of this invention, the entrance pupil (shown at EP) to windshield distance is significantly reduced compared to that with conventional camera arrangements. For example, the EP to windshield distance may be only one-half that which was previously achievable when utilizing a camera designed according to an embodiment of this invention. In one example embodiment, the entrance pupil EP to windshield distance is less than or equal to 10 mm.

Reducing the entrance pupil to windshield distance and being able to have the sensor of the camera closer to the windshield reduces the distortion introduced by the windshield. Windshield glass has a curvature in horizontal and vertical planes. Those curvatures are typically different than each other. The camera image field is affected by the windshield curvature in a way that increases with increasing distance between the sensor and the windshield.

For example, typical windshield configurations introduce barrel-type distortion. As the distance between the camera sensor and the windshield decreases, the radial distortion is reduced across portions of the field of view. Having a reduced entrance pupil to windshield distance reduces the amount of windshield distortion particularly across the median portion of the field of view of the camera and reduces the total amount of image distortion. The distortion reduction is essentially consistent across the median portion of the field of view regardless of the rake angle of the windshield. This is another way in which the disclosed example camera embodiments provide enhanced performance for automotive vehicle applications, such as advanced driver assist features.

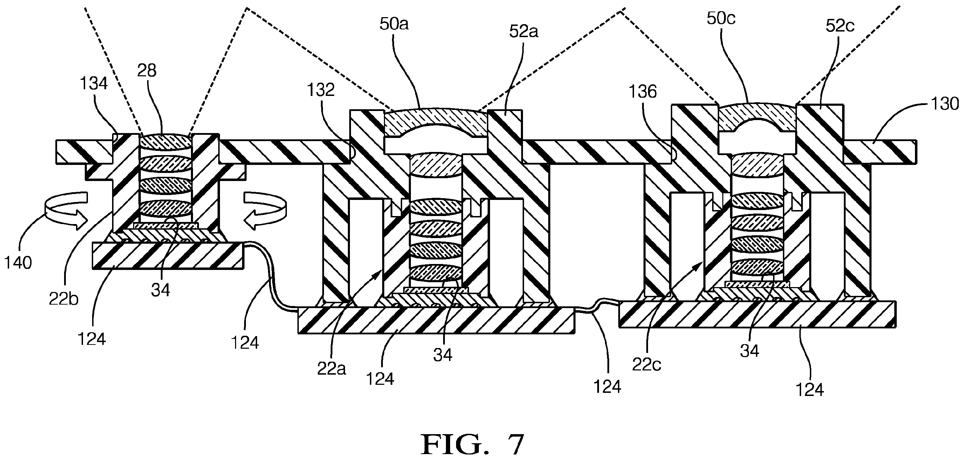

Figure 7 illustrates another example camera configuration. In this example, the camera device 20 includes a plurality of assemblies 22 secured to a circuit board substrate 124 that is at least partially flexible. The substrate 124 allows for the position of one of the assemblies 22 to be adjusted relative to another of the assemblies 22 even after both have been secured to the substrate. There are known circuit board substrate materials and configurations that allow such movement. Those skilled in the art who have the benefit of this description and some knowledge of such known substrates will be able to select an appropriate substrate to meet their particular needs. In this example the substrate 124 has sections or portions that are flexible and others that are rigid. The assemblies 22 are secured to rigid portions of the substrate 124 using a SMT reflow process as described above.

The example of Figure 7 provides a multi-focal camera device including objectives like those described above and shown in Figures 3 and 4. The objectives provide different fields of view for achieving different purposes and different types of camera function. The method of assembling this example embodiment differs from the example of Figures 3 and 4. In this example, after the assemblies 22 are secured to the substrate 124 the assemblies 22 are secured to a mechanical housing reference surface 130.

The assembly process in this example includes aligning the middle assembly 22a with its objective 50 and housing 52a in a desired orientation on the reference surface 130. In the illustrated example, the reference surface 130 includes an opening 132 configured to receive at least a portion of the housing 52a. An adhesive, such as an ultraviolet light-curable adhesive secures the assembly 22a in place. Once the assembly 22a is secured and the adhesive is cured, another one of the assemblies 22b is situated at least partially within an opening 134 in the reference surface 130 with the assembly 22b in a desired orientation and an adhesive secures the assembly 22b in place. The third assembly 22c and its housing 52c is then situated in a desired alignment at least partially within an opening 136 and the assembly 22c is secured in place.

In some examples, the assemblies 22 are arranged on the reference surface 130 to establish stereo vision. In the example of Figure 7 the assemblies 22b and 22c provide stereo vision. The relative roll alignment of the assemblies 22b and 22c should be within a +/- 0.05 degree accuracy for some stereo vision implementations. That level of accuracy in relative alignment cannot be guaranteed during the SMT reflow process so the subsequent alignment on the reference surface 130 is desired. As schematically shown at 140, the roll, pan and tilt alignment of the assemblies 22 can be adjusted using an automated alignment process. Using an ultraviolet light-curable adhesive facilitates establishing a desired assembly orientation and curing the adhesive with UV light exposure to maintain the desired orientation.

Cameras made according to an embodiment of this invention provide smaller overall size requirements and cost savings compared to previous camera arrangements. The manufacturing process becomes simpler, subject to a higher amount of automation with increased reliability and improved yield. Example embodiments are adaptable to different optical field of view requirements and are capable of fitting within tight space constraints for realizing multiple field of view devices. The disclosed embodiments also address issues represented by automotive camera installations, such as reducing windshield distortion.

The preceding description is exemplary rather than limiting in nature. Variations and modifications to the disclosed examples may become apparent to those skilled in the art that do not necessarily depart from the essence of this invention. The scope of legal protection given to this invention can only be determined by studying the following claims.

## Claims

1. A method of making a camera (20), the method comprising:
assembling a plurality of lens elements (28), a sensor (34), and a housing (30) to establish an assembly (22) with each of the lens elements (28) and the sensor (34) at least partially in the housing (30);
situating the assembly (22) adjacent a circuit board substrate (24); and
securing at least the sensor (34) to the circuit board substrate (24) using surface mount technology (SMT), wherein the assembly (22) is fixed relative to the circuit board substrate (24) by the securing;
providing a ball grid array (36) on a side of the sensor (34);
performing the situating by situating the ball grid array (36) adjacent a soldering paste (38) on the circuit board substrate (24); and
performing the securing using reflow soldering;
**characterized in that** the method further comprising:
determining a performance of the camera (20) at an elevated temperature during the securing.

2. The method of any one of claim 1, wherein the assembling includes aligning the lens elements (28) and the sensor (34) in an alignment configured for camera (20) operation prior to the situating and the securing.

3. The method of any one of claims 1 to 2, wherein the housing (30), the plurality of lens elements (28) and the sensor (34) collectively have a height from the circuit board substrate (24) that is less than 13mm.

## Patentansprüche

1. Verfahren zur Herstellung einer Kamera (20), wobei das Verfahren umfasst:
Zusammenbauen mehrerer Linsenelemente (28), eines Sensors (34) und eines Gehäuses (30), um eine Baugruppe (22) herzustellen, wobei sich jedes der Linsenelemente (28) und der Sensor (34) zumindest teilweise in dem Gehäuse (30) befinden;
Positionieren der Baugruppe (22) benachbart zu einem Leiterplattensubstrat (24); und
Befestigen zumindest des Sensors (34) auf dem Leiterplattensubstrat (24) mittels Oberflächenmontagetechnik (SMT), wobei die Baugruppe (22) durch das Befestigen relativ zu dem Leiterplattensubstrat (24) fixiert wird.
Bereitstellen einer Kugelgitteranordnung (36) auf einer Seite des Sensors (34);
Durchführen des Positionierens durch Positionieren der Kugelgitteranordnung (36) benachbart zu einer Lötpaste (38) auf dem Leiterplattensubstrat (24); und
Durchführen des Befestigens mittels Reflow-Löten,
**dadurch gekennzeichnet, dass** das Verfahren weiterhin umfasst:
Bestimmen einer Leistung der Kamera (20) bei einer erhöhten Temperatur während des Befestigens.

2. Verfahren nach einem der Ansprüche 1, wobei das Zusammenbauen das Ausrichten der Linsenelemente (28) und des Sensors (34) in einer für den Betrieb der Kamera (20) konfigurierten Ausrichtung vor dem Positionieren und dem Befestigen umfasst.

3. Verfahren nach einem der Ansprüche 1 bis 2, wobei das Gehäuse (30), die mehreren Linsenelemente (28) und der Sensor (34) zusammen eine Höhe von dem Leiterplattensubstrat (24) haben, die weniger als 13 mm beträgt.

## Revendications

1. Procédé de fabrication d'une caméra (20), le procédé comprenant les étapes consistant à :
assembler une pluralité d'éléments lentilles (28), un capteur (34) et un boîtier (30) pour établir un ensemble (22) avec chacun des éléments lentilles (28) et le capteur (34) au moins partiellement dans le boîtier (30) ;
placer l'ensemble (22) à côté d'un substrat de carte de circuit imprimé (24) ; et
fixer au moins le capteur (34) au substrat de carte de circuit imprimé (24) en utilisant la technologie de montage en surface (SMT), l'ensemble (22) étant rendu fixe par rapport au substrat de carte de circuit imprimé (24) par la fixation ;
fournir une matrice de billes (36) sur un côté du capteur (34) ;
effectuer le placement en plaçant la matrice de billes (36) à côté d'une pâte à souder (38) sur le substrat de carte de circuit imprimé (24) ; et
effectuer la fixation en utilisant le soudage par refusion ;
**caractérisé en ce que** le procédé comprend en outre l'étape consistant à :
déterminer une performance de la caméra (20) à une température élevée pendant la fixation.

2. Procédé selon la revendication 1, dans lequel l'assemblage inclut l'étape consistant à aligner les éléments lentilles (28) et le capteur (34) dans un alignement configuré pour le fonctionnement de la caméra (20) avant le placement et la fixation.

3. Procédé selon l'une quelconque des revendications 1 à 2, dans lequel le boîtier (30), la pluralité d'éléments lentilles (28) et le capteur (34) ont collectivement une hauteur par rapport au substrat de carte de circuit imprimé (24) qui est inférieure à 13 mm.
